# EUROPEAN PATENT APPLICATION

(11) **EP 3 567 633 A1**
(43) Date of publication of application: **13.11.2019**
(21) Application number: 18824991.6
(22) Date of filing: 25.04.2018
(51) Int. Cl.: H01L 27/32, H01L 51/52

(54) **CIRCUIT BOARD AND DISPLAY DEVICE**

(30) Priority: 29.06.2017 CN 201710518353
(71) Applicant: Kunshan Go-Visionox Opto-Electronics Co., Ltd., KunShan City, Jiangsu 215300 (CN)
(72) Inventor: ZHANG, Jinfang, Kunshan Jiangsu 215300 (CN); ZHANG, Lu, Kunshan Jiangsu 215300 (CN); HAN, Zhenzhen, Kunshan Jiangsu 215300 (CN); HU, Siming, Kunshan Jiangsu 215300 (CN); ZHU, Hui, Kunshan Jiangsu 215300 (CN)
(74) Representative: D'Halleweyn, Nele Veerle Trees Gertrudis
(86) International application number: PCT/CN2018/084520
(87) International publication number: WO 2019/001122

(57) **Abstract**

The present invention discloses a circuit board and a display device. The circuit board comprises a display region and a non-display region. The non-display region comprises: a first electrode layer and a second electrode layer disposed on the first electrode layer. Between the first electrode layer and the second electrode layer, and at least on the two sides of the display region, are equal contact areas, enabling contact resistance of the first electrode layer and the second electrode layer to be the same. Current flowing through the two sides of the display area is therefore the same, thus preventing the phenomenon of circuit board scorching.

## Description

### TECHNICAL FIELD

The present disclosure relates to the field of displaying, and more particularly, to a circuit substrate and a display device.

### BACKGROUND TECHNOLOGY

For the conventional OLED display screen, during the producing process of a substrate, when a cathode layer is evaporated in the non-display region on both sides of the display region of the screen body, areas of contact portions of a cathode layer contacting with an electrode layer are not equal on both sides, which may easily cause an offset phenomenon. After the evaporated cathode layer is offset, the lapping areas of the evaporated cathode and the electrode layer are not equal on the left and right sides (two angles) of the display screen, and the resistance on both sides may be inconsistent. The inconsistency of the resistance may easily lead to a difference in current flow direction between the cathode and the electrode layer, resulting in different amounts of heat generated on both sides of the screen, and thus causing the phenomenon of electrically shorted corner of the screen body.

### SUMMARY

Based on the above, regarding the problem of electrically shorted corner caused by the inconsistency of the lapping resistance of a cathode and an electrode layer on both sides (two corners) of the display screen body, there is a need to provide a circuit substrate and a display device with same resistance on both sides of the display screen body.

A circuit substrate is provided, including a display region and a non-display region, the non-display region including:
a first electrode layer, and
a second electrode layer located on the first electrode layer. A contact area of the first electrode layer contacting with the second electrode layer at one side of the display region is equal to that of the first electrode layer contacting with the second electrode layer at another side of the display region.

In this embodiment, the contact area of the first electrode layer contacting with the second electrode layer at one side of the display region is equal to that of the first electrode layer contacting with the second electrode layer at another side of the display region, so that the first electrode layer and the second electrode layer have same contact resistance, and therefore the currents flowing through both sides of the display region are the same, and the phenomenon of electrically shorted corner can be avoided.

In one of the embodiments, the circuit substrate further includes a first insulative layer formed on the first electrode layer, the first insulative layer being provided with two groove regions at least on two sides of the display region. The second electrode layer covers at least a portion of the groove regions and is in contact with the first electrode layer exposed to the groove regions, and the contact area of the first electrode layer contacting with the second electrode layer at one side of the display region is equal to that of the first electrode layer contacting with the second electrode layer at another side of the display region.

In this embodiment, the groove regions are configured to make the second electrode layer contact with the first electrode layer.

In one of the embodiments, the two groove regions on both sides of the display region are symmetrical about a center line of the display region.

In one of the embodiments, the two groove regions on both sides of the display region have equal widths.

In one of the embodiments, the second electrode layer covers the whole of the groove regions and is in contact with the first electrode layer exposed to the groove regions.

In this embodiment, the groove regions are in an equal width, which makes the width of the second electrode layer in contact with the first electrode layer to be the same on both sides after the second electrode layer covers all of the groove regions, and the same resistance can be ensured on both sides of the display region.

In one of the embodiments, the second electrode layer covers at least a portion of a surface of the first insulative layer and at least a portion of the groove regions, and is in contact with the first electrode layer exposed to the groove regions.

In one of the embodiments, the second electrode layer covers the whole surface of the first insulative layer and of the whole of the groove regions, and is in contact with the first electrode layer exposed to the groove regions.

In this embodiment, covering the evaporated area of the second electrode layer with the area of the groove regions may reduce the process difficulty of evaporating the second electrode layer, while the requirement that the contact portions of the second electrode layer contacting with the first electrode layer have equal widths on both sides can be satisfied, and the same resistance on both sides of the display region can be ensured.

In one of the embodiments, the circuit board further includes: a circuit layer, and a ground layer disposed on a side of the circuit layer. A second insulative layer is formed on an upper surface of the circuit layer, and the first insulative layer is formed on upper surfaces of the second insulative layer and the ground layer, and the first electrode layer is in contact with the ground layer.

In this embodiment, the first electrode layer is in contact with the ground layer, which makes the second electrode layer to be conducted with the ground layer through the first electrode layer, so as to achieve signal switching.

In one of the embodiments, the second electrode layer is formed integrally with a cathode in the display region.

In this embodiment, the second electrode layer is formed integrally with a cathode in the display region, which may reduce the production process and improve work efficiency.

In one of the embodiments, the first insulative layer is formed integrally with a pixel defining layer provided in the display region.

In this embodiment, the first insulative layer is formed integrally with a pixel defining layer in the display region, which may reduce the production process and improve work efficiency.

In one of the embodiments, the second electrode layer has a thickness of 0.1mm-0.2mm.

In this embodiment, the second electrode layer with a thickness of 0.1 mm to 0.2 mm may have good electrical conductivity, as well as a reduced resistance, avoiding energy waste due to excessive heat caused by large resistance.

A display device is also provided, including a screen body. The display device further includes the circuit substrate that controls the screen body to emit light.

In this embodiment, the circuit substrate may cause the currents flowing through both sides of the display region of the screen body to be the same, and the phenomenon of electrically shorted corner caused by the uneven currents on both sides of the display region of the screen body can be avoided. Therefore, the display device has a longer service life.

### BRIEF DESCRIPTION OF THE DRAWINGS

FIG. 1 is a schematic cross-sectional diagram of a circuit substrate according to an embodiment of the present disclosure.
FIG. 2 is a structural diagram of a display device according to an embodiment of the present disclosure.

### Description of Reference Signs

10: Circuit Substrate;
100: Second Electrode Layer;
200: Insulative Layer;
300: First Electrode Layer;
210: Groove Region;
400: Second Insulative Layer;
500: Ground Layer;
600: Circuit Layer;
611: Third Insulative Layer;
612: Fourth Insulative Layer;
613: Buffer Layer;
620: Transistor Switching Element;
700: Substrate;
621: Source;
622: Drain;
623: Gate;
624: Active Layer;
625: Pixel;
40: Source Driving Module;
50: Gate Driving Module;
20: Display Device;
800: Display Region;
810: Power Supply Wiring Unit;
820: Welding Unit;
900: Non-Display Region.

### DETAILED DESCRIPTION OF THE EMBODIMENTS

In order to make the purpose, technical scheme and technical effect of the disclosure more clear, the specific embodiments of the present disclosure are described below with reference to the accompanying drawings. It is to be understood that the specific embodiments described herein are merely used to illustrate the disclosure and are not intended to limit the disclosure.

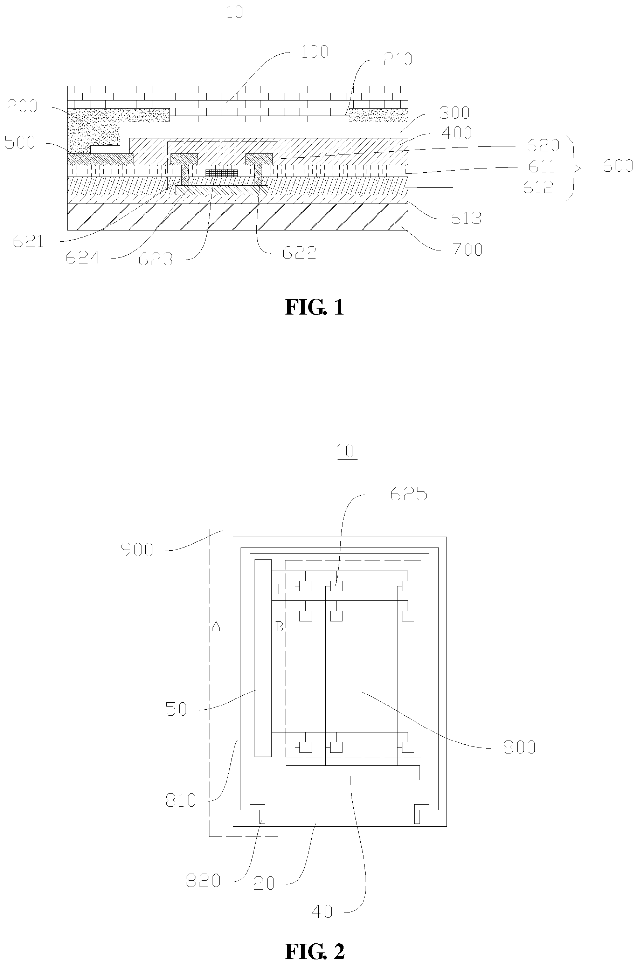

Referring to FIGS. 1-2, FIG. 1 is a cross-sectional figure of FIG. 2 cutting along line A-B. The embodiment of the disclosure provides a circuit substrate 10. The circuit substrate 10 includes a non-display region 900. The non-display region 900 is provided with a first electrode layer 300 and a second electrode layer 100 on the first electrode layer 300. The contact area of the first electrode layer 300 contacting with the second electrode layer 100 at one side of the display region 800 is equal to that of the first electrode layer 300 contacting with the second electrode layer 100 at another side of the display region 800.

Preferably, the circuit substrate 10 further includes a first insulative layer 200 formed on a surface of the first electrode layer 300. The first insulative layer 200 is provided with two groove regions 210 at least on two sides of the display region 800 respectively. It can be understood that the shape of the groove regions 210 is not limited and may be a rectangle, an arc shape or the like. Preferably, the groove regions 210 on the two sides of the display area 800 are symmetrical about a center line of the display region 800. The circuit substrate 10 further includes a second electrode layer 100 formed on the first insulative layer 200. The second electrode layer 100 covers at least a portion of the groove regions 210 and is in contact with the first electrode layer 300 exposed to the groove regions 210. The contact area of the first electrode layer contacting with the second electrode layer at one side of the display region is equal to that of the first electrode layer contacting with the second electrode layer at another side of the display region.

The middle portion of the display device 20 is a display region 800, and the periphery of the display device is a non-display region 900. The non-display region 900 can be provided with a first electrode layer 300, a second electrode layer 100, and groove regions 210. In one embodiment, the display region 800 can be formed into a rectangle. A width and depth of the groove regions 210 can be same or different in the entire non-display region 900, which is not limited herein. Taking the center line of the display region 800 as a symmetry axis, the widths and depths of the groove regions 210 located on the left and right sides of the display region 800 are the same. The width and depth of the groove regions 210 located on the upper and lower sides of the display region 800 can be different or same.

It can be understood that the non-display region 900 can include a non-display region 900 located on the left and right sides of the display region 800 with respect to the center line of the display region 800. In the non-display region 900 on the left and right sides of the display region 800, the contact area of the first electrode layer 300 contacting with the second electrode layer 100 at one side of the display region is equal to that of the first electrode layer 300 contacting with the second electrode layer 100 at an opposite side of the display region, which makes the resistance of the contact portion of the second electrode layer 100 contacting with the first electrode layer 300 at one side of the display region being equal to that of the first electrode layer 300 contacting with the second electrode layer 100 at an opposite side of the display region. Therefore, the current flowing through the first electrode layer 300 and the current flowing through the second electrode layer 100 are same, and as a result, a phenomenon of electrically shorted corner due to different currents flowing through two sides of the display region 800 can be avoided. The second electrode layer 100 can cover and fill only a part of the groove regions 210, or can fill and cover the entire groove regions 210, or cover and fill a part of the groove regions 210 and cover a part of the surface of the first insulative layer 200 or fill the entire groove regions 210 and cover the entire surface of the first insulative layer 200, as long as the widths of contact portions of the second electrode layer 100 contacting with the first electrode layer 300 in the non-display region 900 at one side of the display region 800 is ensured to be equal to that of the first electrode layer 300 contacting with the second electrode layer 100 in the non-display region at another side of the display region 800.

In one of the embodiments, the non-display region 900 of the circuit substrate 10 can be provided with an integrated chip for controlling the circuit substrate 10. The non-display region 900 may be provided with a gate driving module 50 and a source driving module 40. The gate driving module 50 can control ON and OFF state of the pixel switch in the display region 800. The source driving module 40 may provide a data signal to the pixel 625 located in the display region 800 after the pixel switch is switched on. A power supply wiring unit 810 can be further provided around the circuit substrate 10. The power supply wiring unit 810 can be used as a ground line. The power supply wiring unit 810 can be fixed to the circuit substrate 10 via the welding unit 820.

The circuit substrate 10 further includes a base 700 on which the first electrode layer 300 is provided. The substrate 700 is used to support the circuit substrate 10. The base 700 is made of a hard material such as glass or plastic. The first electrode layer 300 is an electrical connection layer to switch a power supply signal. The first electrode layer 300 is made of ITO/Ag/ITO, and evaporated with the anode of the display region 800 to become a part of the anode. The functions of the two anodes are different. The anode located in the display region is used to control pixel emission of the display region, while the anode located in the non-display region only is used to switch the signal. The second electrode layer 100 becomes a part of a common cathode and can be formed by an evaporation process. The first electrode layer 300 and the second electrode layer 100 are in contact with each other, and the first electrode layer 300 is connected to the ground layer 500. The second electrode layer 100 is connected to the ground layer 500 via the first electrode layer 300. The first insulative layer 200 may be composed of silicon oxide, silicon nitride, or a combination of silicon oxide and silicon nitride. The groove regions 210 can be formed by means of photolithography or the like.

In one of the embodiments, the widths of the groove regions 210 of the non-display region 900 disposed on the sides of the display region 800 are equal. The equal width of the groove regions 210 facilitates the control of the process size of the second electrode layer 100 when the second electrode layer 100 is evaporated in the groove regions 210.

In one of the embodiments, the second electrode layer 100 covers the whole of the groove regions 210 and is in contact with the first electrode layer 300 exposed to the groove regions 210. In the manufacturing process of the circuit substrate 10, when the second electrode layer 100 is evaporated, the second electrode layer 100 covers the surface of the first insulative layer 200 and fills the groove regions 210. The widths of the groove regions 210 are equal on two sides of the display region 800. Therefore, through the groove regions 210, the contact areas of the first electrode layer 300 contacting with the second electrode layer 100 at one side of the display region is ensured to be equal to that of the first electrode layer 300 contacting with the second electrode layer 100 at an opposite side of the display region, without changing the evaporation process, and thus it is ensured that the currents flowing through the first electrode layer 300 and the second electrode layer 100 are the same.

In one of the embodiments, the second electrode layer 100 covers at least a portion of the surface of the first insulative layer 200 and at least a portion of the groove regions 210, and is in contacted with the first electrode layer 300 exposed to the groove regions 210. In one of the embodiments, the second electrode layer 100 covers all of the surface of the first insulative layer 200 and all of the groove regions 210, and is in contact with the first electrode layer 300 exposed to the first portion of the groove regions 210. On both sides of the display region 800, a high precision manufacturing process is required to provide the second electrode layer 100 covering only the groove regions 210, which increases the manufacturing cost. Thus, in the process of producing the second electrode layer 100, the second electrode layer 100 may be evaporated in a wider range of widths to cover the groove regions 210 and also to be formed on the surface of the first insulative layer 200, thereby reducing the difficulty of production and the production cost.

In one of the embodiments, the second electrode layer 100 covers a portion of the groove regions 210. The areas of the second electrode layer 100 covered by the second electrode layer 100 in the groove regions 210 are equal on both sides of the display region 800. Therefore, the resistances on both sides of the display region 800 are the same, and the currents flowing through are also the same on both sides, and the phenomenon of electrically shorted corner caused by the uneven current can be avoided.

In this embodiment, the width and depth of the groove regions 210 on the upper side of the display region 800 and the contact areas of the second electrode layer 100 contacting with the first electrode layer 300 are not limited. Instead, only the contact area of the second electrode layer 100 contacting with the first electrode layer 300 at one side of the display region 800 is required to be equal to that of the first electrode layer 300 contacting with the second electrode layer 100 at an opposite of the display region 800, so that the currents on the left and right sides of the screen body are ensured to be equal, which further ensures that the left and right sides of the screen body are not to be shorted. In another embodiment, the contact areas of the second electrode layer 100 contacting with the first electrode layer 300 are equal on all sides of the display region 800, so that the currents on all sides of the screen body are ensured to be equal, which further ensures that all sides of the screen body are not to be shorted.

In one of the embodiments, the circuit substrate 10 further includes a circuit layer 600 and a ground layer 500 disposed on one side of the circuit layer 600. A second insulative layer 400 is formed on the upper surface of the circuit layer 600, and the first electrode layer 300 is formed on the upper surfaces of the second insulative layer 400 and the ground layer 500. The first electrode layer 300 is in contact with the ground layer 500. The circuit layer 600 can control the display of the screen. The second insulative layer 400 may function as a planarizing layer to planarize the surface of the circuit layer 600. The second insulative layer 400 may isolate the circuit layer 600 from the ground layer 500 to reach an insulation purpose. The second electrode layer 100, the first electrode layer 300 and the ground layer 500 are electrically connected to form a loop.

In one of the embodiments, the circuit layer 600 further includes a transistor switching element 620, a third insulative layer 611 and a fourth insulative layer 612. The transistor switching element includes a source 621, a drain 622 and a gate 623. A buffer layer 613 is disposed on the substrate 700, an active layer 624 is disposed on the buffer layer 613 and a fourth insulative layer 612 is disposed over the active layer 624. The gate 623 is evaporated on the fourth insulative layer 612, a third insulative layer 611 is disposed above the gate 623, and the source 621 and the drain 622 are disposed over the third insulative layer 611. The source 621 and the drain 622 are connected to the active layer 624 through the third insulative layer 611 and the fourth insulative layer 612 respectively. The second insulative layer 400 is located above the circuit layer 600 and covers the surface of the circuit layer 600 for planarizing the surface of the circuit layer 600. The circuit layer 600 may be formed with the ground layer 500 integrally, except that unnecessary portions of the ground layer 500 may be etched away during the process, leaving a portion for achieving conduction. Generally, the ground layer 500 is disposed on one side of the circuit layer 600. The third insulative layer 611 is configured to isolate the gate 623, the source 621 and the drain 622. The fourth insulative layer 612 is configured to isolate the active layer 624 and the gate 623. Preferably, the gate 623 can be made of molybdenum. The second insulative layer 400 can be composed of silicon oxide, silicon nitride, or a combination of silicon oxide and silicon nitride. The first insulative layer 200 may also be composed of silicon oxide, silicon nitride, or a combination of silicon oxide and silicon nitride. After the gate 623 is triggered by a voltage, the source 621 and the drain 622 may be turned on. After the source 621 and the drain 622 are turned on, the transistor switching element 620 is controlled to be switched on.

In one of the embodiments, the second electrode layer 100 is formed integrally with a cathode in the display region 800. In this way, the manufacturing process is reduced and the work efficiency is improved.

In one of the embodiments, the first electrode layer 300 is formed integrally with an anode in the display region 800. In this way, the manufacturing process is reduced and the work efficiency is improved.

In one of the embodiments, the first insulative layer 200 is formed integrally with a pixel defining layer in the display region 800. In this way, the manufacturing process is reduced and the work efficiency is improved.

In one of the embodiments, the second electrode layer 100 has a thickness of 0.1 mm to 0.2 mm. Preferably, the second electrode layer 100 has the thickness on the surface of the first insulative layer 200 is same to that in the groove regions 210. The second electrode layer 100 with a thickness of 0.1 mm to 0.2 mm may have good electrical conductivity, as well as a reduced resistance, avoiding energy waste due to excessive heat caused by large resistance.

In one of the embodiments, a buffer layer 613 is further disposed between the active layer 624 and the substrate 700. The buffer layer 613 may isolate the substrate 700 from the active layer 624, and may also play a role of buffering.

The embodiment of the disclosure further provides a display device. The display device includes a screen body, and further includes the circuit substrate 10. The circuit substrate 10 controls the screen to emit light. The second electrode layer 100 is electrically connected with the display region 800. The display region 800 is provided with a cathode and an anode that control the display of the pixel, and the second electrode layer 100 and the cathode may integrally form a common cathode. The currents flowing through both sides of the screen body are same due to the circuit substrate 10, and thus the phenomenon of electrically shorted corner caused by the uneven current on both sides of the screen body can be avoided. Therefore, the display device has a longer service life.

When a feature or element is herein referred to as being "on" another feature or element, it can be directly on the other feature or element or intervening features and/or elements may also be present. It will also be understood that, when a feature or element is referred to as being "connected", "attached" or "coupled" to another feature or element, it can be directly connected, attached or coupled to the other feature or element or intervening features or elements may be present. In contrast, when a feature or element is referred to as being "directly on" another feature or element, there are no intervening features or elements present. The terms "vertical", "horizontal", "left", "right" or the like, as used herein, are for illustrative purposes only.

The above are embodiments of the disclosure described in detail, and should not be deemed as limitations to the scope of the present disclosure. It should be noted that variations and improvements will become apparent to those skilled in the art to which the present disclosure pertains without departing from its spirit and scope. Therefore, the scope of the present disclosure is defined by the appended claims.

## Claims

1. A circuit substrate, comprising:
a display region (800),and
a non-display region (900) including:
a first electrode layer (300), and
a second electrode layer (100)located on the first electrode layer (300),
wherein a contact area of the first electrode layer (300) contacting with the second electrode layer (100) at one side of the display region (800) is equal to that of the first electrode layer (300) contacting with the second electrode layer (100) at another side of the display region (800).

2. The circuit substrate of claim 1, further comprising a first insulative layer (200) formed on the first electrode layer (300), the first insulative layer (200) being provided with two groove regions (210) at least on two sides of the display region (800), wherein the second electrode layer (100) covers at least a portion of the groove regions (210) and is in contact with the first electrode layer (300) exposed to the groove regions (210), and a contact area of the first electrode layer (300) contacting with the second electrode layer (100) at one side of the display region (800) is equal to that of the first electrode layer (300) contacting with the second electrode layer (100) at another side of the display region (800).

3. The circuit substrate of claim 2, wherein the two groove regions (210) on both sides of the display region (800) are symmetrical about a center line of the display region (800).

4. The circuit substrate of claim 2, wherein the two groove regions (210) on both sides of the display region (800) have equal widths.

5. The circuit substrate of claim 2, wherein the second electrode layer (100) covers the whole of the groove regions (210) and is in contact with the first electrode layer (300) exposed to the groove regions (210).

6. The circuit substrate of claim 2, wherein the second electrode layer (100) covers at least a portion of a surface of the first insulative layer (200) and at least a portion of the groove regions (210), and is in contact with the first electrode layer (300) exposed to the groove regions (210).

7. The circuit substrate of claim 6, wherein the second electrode layer (100) covers the whole surface of the first insulative layer (200) and the whole of the groove regions (210), and is in contact with the first electrode layer (300) exposed to the groove regions (210).

8. The circuit substrate of any one of claims 1 to 7, further comprising a circuit layer (600), and a ground layer (500) disposed on a side of the circuit layer (600), wherein a second insulative layer (400) is formed on an upper surface of the circuit layer (600), and the first insulative layer (300) is formed on upper surfaces of the second insulative layer(400) and the ground layer (500),and the first electrode layer (300) is in contact with the ground layer (500).

9. The circuit substrate of claim 1, wherein the second electrode layer (100) is formed integrally with a cathode in the display region (800).

10. The circuit substrate of claim 1, wherein the first insulative layer (200) is formed integrally with a pixel defining layer provided in the display region (800).

11. The circuit substrate of claim 1, wherein the second electrode layer (100) has a thickness of 0.1mm-0.2mm.

12. A display device, comprising a screen body, wherein the display device further comprises the circuit substrate of any one of claims 1 to 11, and the circuit substrate controls the screen body to emit light.
